(19) Europäisches Patentamt
European Patent Office
Office européen des brevets

(11) **EP 4 116 873 A1**

(12) **EUROPEAN PATENT APPLICATION**

(43) Date of publication:
**11.01.2023 Bulletin 2023/02**

(21) Application number: **21184910.4**

(22) Date of filing: **09.07.2021**

(51) International Patent Classification (IPC):
*G06K 9/00* (2022.01)   *G06K 9/62* (2022.01)

(52) Cooperative Patent Classification (CPC):
**G06K 9/6262; G06V 10/50; G06V 20/56**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Aptiv Technologies Limited**
**14004 St. Michael (BB)**

(72) Inventors:
• **Porebski, Jakub**
**30-669 Kraków (PL)**

• **Kogut, Krzysztof**
**30-612 Kraków (PL)**
• **Rózewicz, Maciej**
**30-702 Kraków (PL)**
• **Farag, Mohamed**
**31-553 Krakow (PL)**

(74) Representative: **Hoffmann Eitle**
**Patent- und Rechtsanwälte PartmbB**
**Arabellastraße 30**
**81925 München (DE)**

(54) **OCCUPANCY GRID CALIBRATION**

(57)     A computer-implemented method and system for calibrating an occupancy grid mapping a vehicle environment are disclosed. The method comprises identifying a feature of an occupancy grid mapping a vehicle environment, wherein the occupancy grid provides a primary representation of the feature; determining a quality level of the primary representation of the feature; determining if the quality level satisfies a quality criterion; and adjusting a calibration of the occupancy grid if the quality level fails to satisfy the quality criterion, wherein adjusting a calibration of the occupancy grid comprises adjusting at least one parameter used to generate the occupancy grid to cause the quality level to satisfy the quality threshold.

EP 4 116 873 A1

## Description

## Technical field

The present disclosure relates to the calibration of occupancy grids used to map a vehicle environment.

## Background

With the current development of motor vehicles which are fully autonomous and/or fitted with ADAS (Advanced Driver Assistance Systems), many techniques have been developed for the reliable estimation of the vehicle environment, on the basis of a large amount of data coming from one or more sensors of the vehicle. A widely used approach involves detecting objects or obstacles in the environment of the vehicle, using one or more sensors, then in fusing the data from various sensor sources into an occupancy grid containing cells associated with respective occupancy and/or free space probabilities. The occupancy probability of each cell is calculated using a suitable sensor model which converts the data relating to detected objects and additional information into occupancy and/or free space probabilities.

In order to provide an accurate and reliable representation of the vehicle environment it is necessary to calibrate the occupancy grid, taking into account the distinctive characteristics of the sources of input information. It follows that each input sensor source requires different sensor modelling calibration. Moreover, in the occupancy grid algorithm itself the filtering parameters must be tuned correctly in order to filter noisy data properly.

## Summary

According to a first aspect of the present disclosure there is provided a computer-implemented method of calibrating an occupancy grid mapping a vehicle environment, the method comprising identifying, by a controller, a feature of an occupancy grid mapping a vehicle environment, wherein the occupancy grid provides a primary representation of the feature; determining, by the controller, a quality level of the primary representation of the feature; determining, by the controller, if the quality level satisfies a quality criterion; and adjusting, by the controller, a calibration of the occupancy grid if the quality level fails to satisfy the quality criterion, wherein adjusting a calibration of the occupancy grid comprises adjusting at least one parameter used to generate the occupancy grid to cause the quality level to satisfy the quality threshold..

Determining a quality level of the primary representation of the feature may comprise obtaining, by the controller, reference information providing a secondary representation of the identified feature, wherein the reference information is obtained independently of the occupancy grid; and comparing, by the controller, the secondary representation of the identified feature with the primary representation of the feature from the occupancy grid to determine a disparity between the secondary representation and the primary representation.

Determining if the quality level satisfies a quality criterion may comprise determining if the disparity satisfies a tolerance threshold.

Adjusting a calibration of the occupancy grid may comprise adjusting at least one parameter used to generate the occupancy grid to reduce the disparity between the secondary representation and the primary representation.

Adjusting at least one parameter used to generate the occupancy grid to reduce the disparity between the secondary representation and the primary representation may comprise applying a gradient descent algorithm to the at least one parameter to minimise the disparity.

The method may further comprise storing, at a memory, simulation data modelling the dependence of the disparity on the one or more parameters used to generate the occupancy grid.

The reference information providing a secondary representation of the identified feature may comprise positional data of an object corresponding to the feature, the positional data being obtained from a high definition map module.

The reference information providing a secondary representation of the identified feature may comprise dynamic positional data obtained from an object tracker module.

The at least parameter may comprise one or more of: a decay mean lifetime, a free space confidence level, sensor model type, and a detection uncertainty value.

According to a second aspect of the present disclosure there is provided a computer program product comprising computer readable instructions that, when executed by a processor, cause the computer to perform the method of the first aspect.

According to a third aspect of the present disclosure there is provided a system for calibrating an occupancy grid mapping a vehicle environment, the system comprising a controller configured to: identify a feature of an occupancy grid mapping a vehicle environment, wherein the occupancy grid provides a primary representation of the feature; determine a quality level of the primary representation of the feature; determine if the quality level satisfies a quality criterion; and adjust a calibration of the occupancy grid if the quality level fails to satisfy the quality criterion, wherein adjusting a calibration of the occupancy grid comprises adjusting at least one parameter used to generate the occupancy grid to cause the quality level to satisfy the quality threshold.

## Brief Description of the Drawings

So that the present disclosure may be fully understood by the skilled person, examples will be described with reference to the accompanying drawings, in which:

Figure 1 illustrates a vehicle;
Figure 2 is a schematic block diagram of a device for mapping the surroundings of the vehicle;
Figure 3 is a schematic block diagram of an occupancy grid determiner;
Figure 4A illustrates an occupancy grid;
Figure 4B illustrates a drivable corridor;
Figure 5 illustrates a calibration parameter space;
Figure 6 is an initial grid representation of a traffic sign;
Figure 7 is a maximum-likelihood approximation of the traffic sign;
Figure 8 shows the changes to the representation of the traffic sign with varying parameters; and
Figure 9 is a flow chart illustrating example operations performed in example embodiments of the present disclosure.

**Detailed Description**

Example embodiments of the present disclosure provide for improved calibration of an occupancy grid mapping a vehicle environment. One or more features represented in the occupancy grid are identified and the quality of the representation of the one or more features is measured using one or more key performance indicators. If the quality of the representation is determined not to meet a satisfactory level then the calibration of one or more parameters used to generate the occupancy grid is adjusted so that a satisfactory representation of the feature on the occupancy grid is obtained.

In one embodiment, the representation of a drivable corridor is compared with object tracking information obtained from an object tracking system. The position of a second vehicle in a lane ahead of the ego-vehicle may be estimated from the occupancy grid as the terminus of a drivable corridor ahead of the ego-vehicle. This positional information may then be compared with object tracker data obtained from an object tracking system to determine a disparity between the positional data obtained from the occupancy grid (corresponding to the end of the drivable corridor) and the positional data obtained from the object tracking system. Since the object tracking system is assumed to be more accurate than the positional data obtained from the occupancy grid, the disparity gives a quality level of the positional data obtained from the occupancy grid. If the disparity fails to satisfy a quality criterion (for example if the disparity is above a threshold) then one or more parameters used to generate the occupancy grid are adjusted to reduce the disparity to an acceptable level.

In another embodiment, a portion of the occupancy grid representing an object (such as a traffic sign) is compared with positional information obtained from a high definition (HD) maps module. An ideal representation of the object would involve a single cell of the occupancy grid being designated as being occupied. The resolution of the representation of the object in the occupancy grid is compared to a quality criterion. If the representation of the object does not satisfy the quality criterion then one or more parameters used to generate the occupancy grid are adjusted to improve the representation of the object in the occupancy grid to an acceptable level.

According to various embodiments, the amount of adjustment of the parameters used to generate the occupancy grid is based on simulation data. The disparity level may be plotted as a function of one or more parameters used to generate the occupancy grid. As such, the link between disparity levels and the various parameters used to generate the occupancy grid can be modelled from simulation data. An optimisation algorithm such as a gradient descent algorithm may be employed to determine the level of adjustment of the parameters that is required in order to minimise the disparity between the occupancy information and the reference information. The parameters are then adjusted, thereby re-calibrating the occupancy grid.

Such an arrangement is advantageous for several reasons. The occupancy grid may be recalibrated automatically. This is useful in situations where the vehicle environment changes, for example when the vehicle experiences a change in weather or light conditions. It is possible to perform the re-calibration without detailed knowledge of the ground truth for the entire vehicle environment. Instead, one or more features are identified from the occupancy grid and ground truth information for those particular features are analysed to determine the quality level of the occupancy grid. As such, example embodiments are more computationally efficient than prior approaches.

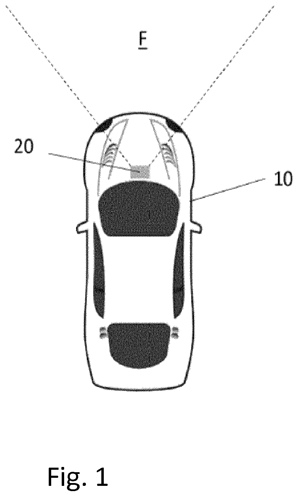

Figure 1 shows a vehicle 10 equipped with a device 20 for mapping the environment of the vehicle 10 according to one or more embodiments of the present disclosure. The device may have various components mounted on the vehicle 10 at different locations, but for the sake of simplicity the device 20 is depicted as a single component mounted on the vehicle. The device 20 includes one or more sensors for sensing objects and/or free space in the surroundings of the vehicle 10. For example, the device 20 includes one or more radar sensors, lidar sensors, ultrasonic sensors and/or imaging sensors for detecting objects in the surroundings of the vehicle 10. The device 20 is configured to map the environment of the vehicle 10 according to the methods disclosed herein.

In the device 20, the sensors are mounted on the vehicle 10 such that they are able to sense objects within a field of view F of the vehicle surroundings, and in particular to sense the distance to objects in a plurality of directions from the vehicle 10 in the field of view. For example, sensors may be mounted at the front corners of the vehicle 10. The field of view is depicted as extending in the frontward direction of the vehicle 10, although the field of view could extend in any direction of the vehicle. Further, the field of view could be a partial view of the vehicle's surroundings, or it could be an entire panoramic view of the surroundings. It will be appreciated that the number, position and orientation of the sensors of the device 20 can be selected to achieve the desired field of view.

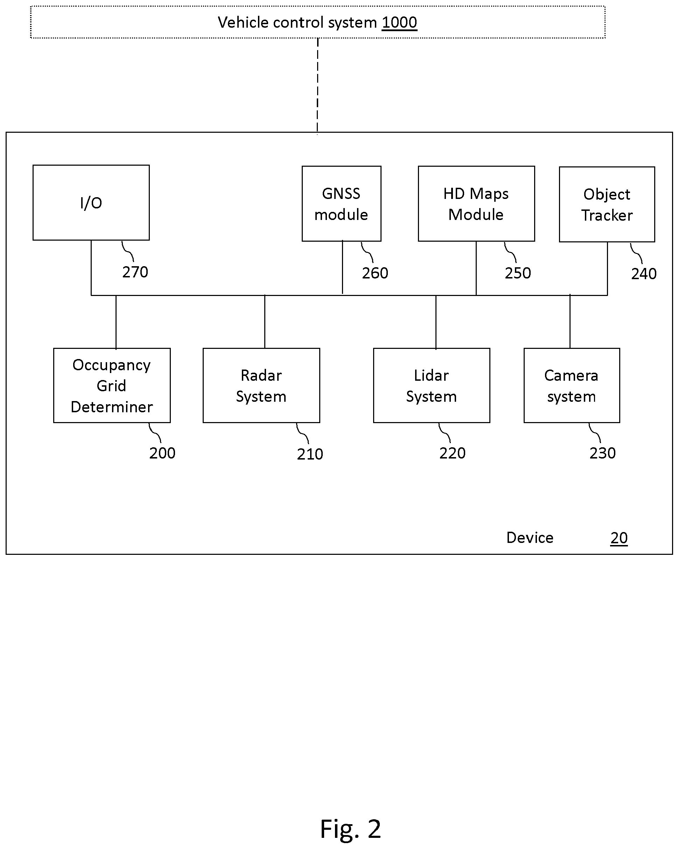

Figure 2 is a schematic block diagram illustrating components of the device 20 in accordance with one embodiment.

The device 20 includes an occupancy grid determiner 200 configured to implement logic to determine an occupancy grid mapping the vehicle environment. The device 20 includes sensor systems including a radar system 210, a lidar system 220 and a camera system 230. In some embodiments, the device 20 may include an ultrasound system (not shown).

The radar system 210 includes one or more radar antennas configured to emit radar signals, for example modulated radar signals, e.g. a Chirp-Signal. A signal may be acquired or detected at one or more antennas and is generally referred to as a return signal. The return signal(s) may result from a reflection of the emitted radar signal(s) on an obstacle. The one or more antennas may be provided individually or as an array of antennas, wherein at least one antenna of the one or more antennas emits the radar signal(s), and at least one antenna of the one or more antennas detects the return signal(s). The detected or acquired return signal(s) represents a variation of an amplitude/energy of an electromagnetic field over time.

The lidar system 220 is similarly configured to emit signals to the surroundings of the vehicle 10 and to detect reflected signals from the surroundings of the vehicle and therefore detect objects in the surroundings.

The camera system 230 includes one or more cameras that are mounted on the vehicle 10 to provide images and/or video of the road surface along which the vehicle 10 is driving. The one or more cameras are positioned such that image and/or video data is captured of the vehicle surroundings. For example, cameras may be located around the vehicle to obtain a 360-degree field of view of the vehicle surroundings. The camera system 230 may include processing means that is configured to analyse images and/or video obtained by the cameras to extract information therefrom. For example, deep learning and neural networks may be employed to analyse the images and/or video to perform segmentation analysis to identify objects in the vehicle's surroundings.

The device 20 includes an object tracker 240. The object tracker 240 is operable to identify dynamic objects from image data obtained by one or more sensor systems such as the radar system 210, lidar system 220 and/or the camera system 230. The object tracker 240 is operable to obtain the shape, dimensions, speed and orientation of dynamic objects in the vehicle's surroundings from radar, lidar and image data. For example, the object tracker 240 may be operable to track other vehicles or pedestrians in the vehicle environment. The object tracker 240 may identify the shape of an identified object using segmentation analysis of a camera image and identify the object as a car. The object tracker 240 tracks the object in the field of view of the vehicle 10 and can extract information regarding the behaviour of the tracked object such as the speed of the tracked object.

The device 20 includes a high definition (HD) maps module 250. The HD maps module 250 is operable to obtain up-to-date HD map data of the environment in which the vehicle 10 is travelling. The HD maps module 250 may download HD map data for use offline. The HD maps module 250 may also have a network connection to obtain HD map data online.

The device 20 includes a GNSS module 260 may be configured to obtain the vehicle's current position using the global positioning system (GPS), GLONASS, Galileo or any other satellite navigation system. Positioning data obtained by the GNSS module 260 may be used to plot the position of the vehicle 10 on an HD map obtained by the HD maps module 250.

The device 20 includes input/output (I/O) 270 to allow the device 20 to interact with other systems. For example, the device 20 may interact with a vehicle control system 1000 that is operable to control the movement (such as steering, acceleration and braking) of the vehicle 10. Thus, information obtained by the device 20 may be used by the vehicle control system 1000 to drive the vehicle 10 along a given route.

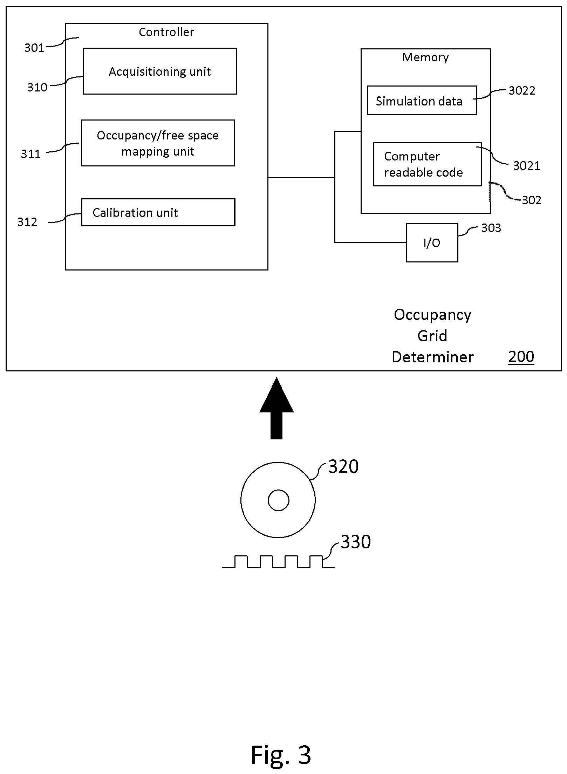

Figure 3 shows a schematic block diagram of the occupancy grid determiner 200 for mapping the environment of the vehicle 10 according to one or more embodiments. The occupancy grid determiner 200 includes a controller 301, memory 302, and input/output 303.

The controller 301 includes an acquisitioning unit 310, an occupancy/free space mapping unit 311, and an occupancy grid calibration unit 312.

The acquisitioning unit 310 is configured to acquire sensor data (e.g. range and range rate data) from the one or more sensors (such as the sensors of the camera system, radar system and/or lidar system) and compute the location of one or more objects in the vehicle's surroundings from the sensor data. In particular, for embodiments including a radar, lidar or ultrasound sensor, the acquisitioning unit 310 may acquire the return signal (e.g. detected at the one or more antennas) and may apply an analogue-to-digital (A/D) conversion thereto. The acquisitioning unit 310 may convert a delay between emitting the signal(s) and detecting the return signal(s) into range data indicating the distance between an object and the vehicle 10, and the direction of the object is also calculated from the return signal(s) (e.g. from comparing multiple signals from different antennas). The delay, and thereby the range data, may be acquired by correlating the return signal(s) with the emitted radar signal(s). Alternatively or additionally, the acquisitioning unit 310 may acquire image data from one or more stereo cameras and perform a stereo algorithm on the image data to calculate the distance to an object and the vehicle 10.

The acquisitioning unit 310 is further configured to acquire reference information from a secondary source such as the object tracker 240 or the HD maps module 250 and to provide the reference information to the calibration unit 312.

The occupancy/free space mapping unit 311 is configured to acquire the coordinates of the detected objects or free space calculated by the acquisitioning unit 310, and to calculate an occupancy grid in the earth frame of reference based on the data. More specifically, the occupancy/free space mapping unit 311 includes a sensor model which takes the acquired detection data from the acquisitioning unit 310 as an input and generates an occupancy grid from the data (it will be appreciated that any sensor model may be used - for example any physical model, deterministic model or inverse sensor model). For example, the occupancy/free space mapping unit 311 may receive a plurality of detections from the acquisitioning unit, each detection including a range value and an azimuth (indicating the distance and direction of the detected object or free space with respect to the vehicle). The detections may then be converted into a set of occupancy and/or free space probabilities for cells in an occupancy grid. The occupancy/free space 311 is configured to use an appropriate sensor fusion model to combine sensor data obtained from different types of sensors, such as radar, lidar and image data.

The calibration unit 312 is configured to identify features of the occupancy grid for which the quality of the representation provided by the occupancy grid is measured. The calibration unit 312 determines the quality level for the identified one or more identified features and further determines if the quality level is satisfactory. For example, the position of an identified object in the occupancy grid is compared, by the calibration unit 312, with the position of the object obtained from the object tracker 240. A disparity between the two measured positions is obtained. If the quality level is not satisfactory, for example if the disparity is greater than or equal to a threshold then the calibration unit 312 determines to re-calibrate the occupancy grid. The calibration unit 312 uses simulation data that models the dependence of the disparity on various parameters used to generate the occupancy grid. The calibration unit 312 may be configured to use an optimisation algorithm such as a gradient descent algorithm to identify parameter values that result in a minimisation of the disparity value. The calibration unit 312 adjusts the parameters to the identified parameter values, thereby re-calibrating the occupancy grid.

The memory 302 includes working memory (e.g. a random access memory) and an instruction store storing code 3021 defining a computer program including computer-readable instructions which, when executed by the controller 301, cause the controller 301 to perform the processing operations described herein. The instruction store may include a ROM (e.g. in the form of an electrically-erasable programmable read-only memory (EEPROM) or flash memory) which is pre-loaded with the computer-readable instructions. Alternatively, the instruction store may include a RAM or similar type of memory, and the computer-readable instructions can be input thereto from a computer program product, such as a computer-readable storage medium such as a CDROM 320 etc. or a computer-readable signal 330 carrying the computer-readable instructions. The memory 302 also stores simulation data 3022 that is used by the calibration unit 313 to determine the amount of calibration of certain parameters used to generate the occupancy grid.

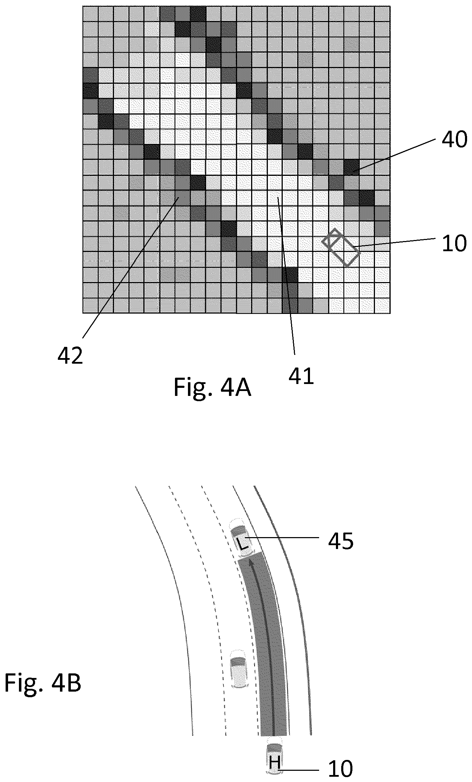

An exemplary occupancy grid is shown in Figure 4A. The occupancy grid includes a grid of cells. The cell positions are defined using an occupancy grid coordinate system. The coordinate system may be a right-handed coordinate system, the origin being attached, for example at a corner of the grid. The coordinates of the bottom right cell may be designated as (0,0,0) with the coordinates of each neighbouring cell increasing by one in the direction of movement from the first cell. Clearly, any other cell in the occupancy grid may be designated as the origin having coordinates (0, 0, 0). The z-axis is defined in 2D applications to correctly define the direction of rotation, but may also be used to define the positions of cells in a 3D grid for 3D applications. The occupancy grid may be defined in an earth frame of reference, a vehicle frame of reference or another frame of reference. For example, the occupancy grid may be generated in the vehicle frame of reference, and as such the coordinates of the occupancy grid each correspond to a fixed coordinate in the vehicle frame of reference. Each cell may take an occupancy value indicating whether that position is occupied by an object or not. For example, in the illustrated example in Figure 4A, the darker cells, such as cell 40 indicate that the cell is occupied by an object (and corresponds to the position where the sensors detect an object). On the other hand, the white cells 41 indicate that the cell is not occupied by an object and may be designated as free space. The white cells 41 shown in Figure 4 may be modelled as a drivable corridor in front of the vehicle 10. Finally, the grey cells 42 indicate that there is no knowledge of the occupancy of that cell (for instance because another object lies in between that cell and the sensors, such that no signal reaches the position corresponding to that cell. The occupancy value for each cell is calculated from the detections of the acquired by the acquisitioning unit 310 from the various sensor systems of the device 20. For example, based on the range, azimuth and uncertainties of the detections, the occupancy evidence for each cell is calculated, which describes the probability that each cell is the origin of a detection (i.e. contains the location of the detection). The occupancy grid may be a Bayesian occupancy grid wherein the probability of the cell occupancy is calculated from evidence values obtained from the object and/or free space detections, although any type of occupancy grid may be used without departing from the present disclosure. For example, the occupancy probability of a cell may be given by *p(occ) = 0.5 + 0.5 · p(c/d),* where *p(c/d)* is the occupancy evidence value of cell c given an object detection d. Equally, the free space probability may be given by *p(free) = 0.5 + 0.5 . p(c/f),* where *p(c/f)* is the free space evidence value of cell c given a free space detection *f.* In some embodiments, the occupancy grid may include a grid of probabilities that each cell is occupied based on the *p(occ)* values *and/or p(free)* values. Each cell may then be assigned a probability value that the cell is occupied based on the object and/or free space detections. The occupancy grid may be rendered as, for example, a greyscale image or similar based on the probability value (0 being white/black, 1 being black/white). Each cell may instead be assigned as "occupied" if the occupancy probability is above an upper threshold, or "empty" if the occupancy probability is below a lower threshold. The occupancy grid may be rendered in two colours accordingly. In some embodiments each grid cell may only be assigned "empty" or "occupied". In other embodiments a cell may further be assigned as "unknown" if the occupancy probability is between the upper and lower threshold, when the thresholds differ. It will be appreciated that other methods may be used to generate the occupancy grid from the detection data. For example, a Dempster-Shafer framework may be used to generate the occupancy grid. Any suitable motion detection algorithm may be performed on the occupancy grid generated under any framework by measuring the change in the occupancy values of the occupancy grid between time frames.

Furthermore, confidence values may be determined as a weighting for each occupancy or free space probability value. For example, for every sensor or for each detection in a particular set, an existence probability parameter may be defined as a confidence level for the evidence obtained from the sensor or detection. The confidence level may then be used as a weighting to determine the occupancy and free space evidence values within the acquisitioning unit 310. As such, it is possible to comply with the International Organization for Standardization (ISO) requirement for automotive standards to ensure that every sensor detection has an existence probability parameter, which indicates the reliability of the measurement.

In embodiments of the present disclosure, the acquisitioning unit 310 firstly computes the detection or free space evidence for a grid cell based on the sensor parameters. Secondly this value is multiplied by the sensor and/or detection confidence level. The output is used as p(c | d) value as described above.

The occupancy grid provides occupancy and/or free space information at a particular point in time. The behaviour of objects over time is accounted for by incorporating a decay rate. The decay rate works by artificially diminishing the evidence values (such as occupancy or free space probability values) in the entire grid over time. The key limitation of sensor and free space modelling is the simplification of many physical dependencies, for instance various occupancy grid algorithms assume data completion and cell independence. During the process of integrating multiple pieces of evidence, hidden dependencies are omitted. Consequently, the results tend to become overconfident. In order to deal with this problem, exponential information decay may be applied. This increases the uncertainty of grid cells while preserving the overall variance of the map. The exponential decay may be described as:

$$p(t + \Delta t) = (p(t) - 0.5).e^{-\frac{\Delta t}{\lambda}} + 0.5$$

where p(t) is probability of the cell at time t; $\Delta t$ is the time elapsed between two decay operations; and A is the decay mean lifetime.

The behaviour of the decay depends on the update rate of the occupancy grid. The decay tends towards the most uncertain probability value, which is 0.5 for the Bayesian inference method.

Figure 4B shows a vehicle 10 driving along a road. The environment of the vehicle may be modelled by the occupancy grid. The vehicle 45 may be detected by one or more of the camera, radar and/or lidar systems and included as an object detection in an occupancy grid. The space in front of the vehicle 10 up to the vehicle 45 may be designated by the occupancy grid as free space and marked as a drivable corridor. The object tracker 240 is also configured to detect and track the vehicle 45. The position of the vehicle 45 with respect to the vehicle 10 as determined by the occupancy grid may be compared with the position of the vehicle 45 with respect to the vehicle 10 as determined by the object tracker 240. If the disparity between the two determined positions for the vehicle 45 is above a threshold then it is determined that a re-calibration should be performed on the occupancy grid.

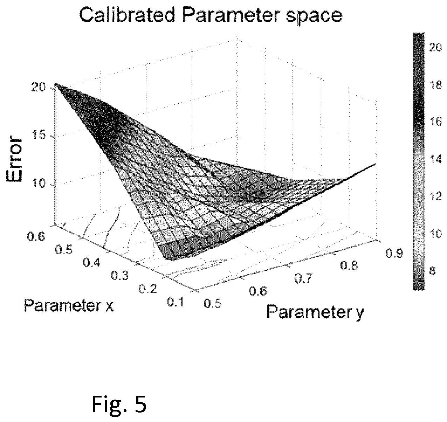

Figure 5 illustrates a calibration space. The error, i.e. disparity between measured position of an object according to the object tracker and according to the occupancy grid is plotted as a function of parameters x and y, where x is a confidence score of an occupancy probability and y is the confidence score of a free space mass. The data used to create the plot was obtained from numerous simulations. The simulation data thus obtained may be stored by the occupancy grid determiner 200. It can be seen that the error may be minimised by adjusting the parameters x and y to certain values. The calibration unit 312 may use an optimisation algorithm to determine the values of parameters x and y required to minimise the error.

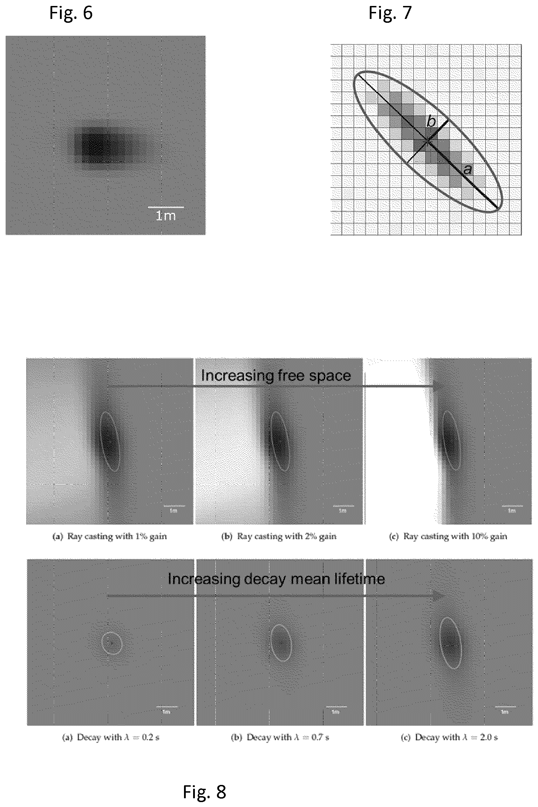

In accordance with another embodiment of the present disclosure, object detections determined by the occupancy grid may be compared with information obtained from the HD maps module 250. The position of a feature of the occupancy grid identified as corresponding to an object detection is compared to the HD map data. In the following example, the occupancy grid provides a representation of a traffic sign. The HD maps module 250 provides information about the position of the traffic sign. An example of the an initial grid representation of a traffic sign is presented in Figure 6. After initial object extraction, a Gaussian representation is extracted using, for example, a maximum-likelihood approximation as shown in Figure 7.

The occupancy grid representation of the traffic sign should be as small as possible (ideally the traffic sign should occupy only a single grid cell), and the preferred traffic sign representation should be circular. Therefore, for measuring the quality level of the representation of the sign in the occupancy grid, the Gaussian ellipse area and its circularity may be utilized.

The calibration update step is again the result of various tuning rules defined using simulation and experimental evaluation. For example, two tuning rules for the traffic sign in front of the vehicle are presented in Figure 8. The top row of Figure 8 illustrates the impact of increasing the free space confidence level. The area of the occupancy grid that represents the detected object decreases as the free space confidence level is increased. Therefore, in this case, increasing the free space confidence level leads to an improved resolution of the representation of the feature in the occupancy grid.

The bottom row of Figure 8 illustrates the impact of varying the decay rate of the occupancy grid by varying the decay mean lifetime ($\lambda$) value. The decay mean lifetime is inversely proportional to the decay rate. Therefore, as the decay mean lifetime is decreased, the decay rate is increased. Decreasing the decay mean lifetime, thereby increasing the decay rate of the occupancy grid, causes the area of a feature represented by the occupancy grid, such as the traffic sign, to decrease. Therefore, in this case, increasing the decay rate of the occupancy grid (by decreasing the decay mean lifetime) leads to an improved resolution of the representation of the feature in the occupancy grid.

Other parameters that can be varied include the sensor model type and a detection uncertainty value. For example, the representation of a traffic sign on an occupancy grid may vary depending on whether a 1D Range, a 1D Azimuth or a 2D Gaussian modelling technique is used.

Therefore, when it is determined that the representation of the sign in the occupancy grid does not satisfy a quality criterion, for example if the representation of an object such as a traffic sign occupies too many grid cells of the occupancy grid then an optimisation algorithm may be used to vary the free space confidence level, decay mean lifetime, sensor model type and/or detection uncertainty value to improve the representation of the traffic sign in the occupancy grid.

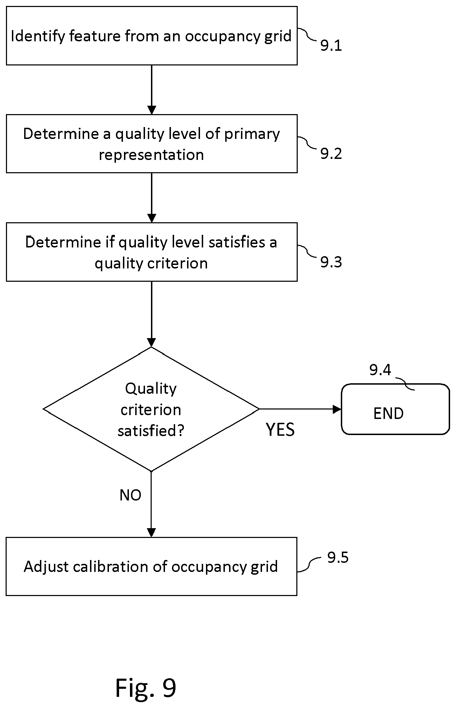

Figure 9 is a flow chart illustrating operations carried out in embodiments of the present disclosure.

At step 9.1, a feature of an occupancy grid is identified. The occupancy grid may be considered to provide a primary representation of the feature.

At step 9.2, a quality level of the primary representation of the feature is determined. The quality level may be determined by comparing the representation obtained from the occupancy grid with reference information providing a secondary representation of the identified feature. The reference information is obtained independently of the occupancy grid and may be obtained from a secondary source such as an object tracker or HD maps data. The secondary representation of the identified feature may be compared with the primary representation of the feature from the occupancy grid to determine a disparity between the secondary representation and the primary representation.

At step 9.3 it is determined if the quality level satisfies a quality criterion. If the quality criterion is satisfied then the process ends at step 9.4. Determining if the quality level satisfies a quality criterion may include determining if the disparity satisfies a tolerance threshold.

If the quality criterion is not satisfied then an adjustment of the calibration of the occupancy grid is performed. Adjusting a calibration of the occupancy grid may involve adjusting at least one parameter used to generate the occupancy grid to cause the quality level to satisfy the quality criterion. For example, the free space confidence level, decay mean lifetime, sensor model type and/or detection uncertainty value may be varied to improve the representation of the feature.

By virtue of the foregoing capabilities of the example aspects described herein, which are rooted in computer technology, the example aspects described herein improve computers and computer processing/functionality, and also improve the field(s) of at least autonomous driving. In the foregoing description, aspects are described with reference to several embodiments. Accordingly, the specification should be regarded as illustrative, rather than restrictive. Similarly, the figures illustrated in the drawings, which highlight the functionality and advantages of the embodiments, are presented for example purposes only. The architecture of the embodiments is sufficiently flexible and configurable, such that it may be utilized in ways other than those shown in the accompanying figures. Software embodiments presented herein may be provided as a computer program, or software, such as one or more programs having instructions or sequences of instructions, included or stored in an article of manufacture such as a machine-accessible or machine-readable medium, an instruction store, or computer-readable storage device, each of which can be non-transitory, in one example embodiment. The program or instructions on the non-transitory machine-accessible medium, machine-readable medium, instruction store, or computer-readable storage device, may be used to program a computer system or other electronic device. The machine- or computer-readable medium, instruction store, and storage device may include, but are not limited to, floppy diskettes, optical disks, and magneto-optical disks or other types of media/machine-readable medium/instruction store/storage device suitable for storing or transmitting electronic instructions. The techniques described herein are not limited to any particular software configuration. They may find applicability in any computing or processing environment. The terms "computer-readable", "machine-accessible medium", "machine-readable medium", "instruction store", and "computer-readable storage device" used herein shall include any medium that is capable of storing, encoding, or transmitting instructions or a sequence of instructions for execution by the machine, computer, or computer processor and that causes the machine/computer/computer processor to perform any one of the methods described herein. Furthermore, it is common in the art to speak of software, in one form or another (e.g., program, procedure, process, application, module, unit, logic, and so on), as taking an action or causing a result. Such expressions are merely a shorthand way of stating that the execution of the software by a processing system causes the processor to perform an action to produce a result. Some embodiments may also be implemented by the preparation of application-specific integrated circuits, field-programmable gate arrays, or by interconnecting an appropriate network of conventional component circuits.

Some embodiments include a computer program product. The computer program product may be a storage medium or media, instruction store(s), or storage device(s), having instructions stored thereon or therein which can be used to control, or cause, a computer or computer processor to perform any of the procedures of the example embodiments described herein. The storage medium/instruction store/storage device may include, by example and without limitation, an optical disc, a ROM, a RAM, an EPROM, an EEPROM, a DRAM, a VRAM, a flash memory, a flash card, a magnetic card, an optical card, nanosystems, a molecular memory integrated circuit, a RAID, remote data storage/archive/warehousing, and/or any other type of device suitable for storing instructions and/or data.

Stored on any one of the computer-readable medium or media, instruction store(s), or storage device(s), some implementations include software for controlling both the hardware of the system and for enabling the system or microprocessor to interact with a human user or other mechanism utilizing the results of the embodiments described herein. Such software may include without limitation device drivers, operating systems, and user applications. Ultimately, such computer-readable media or storage device(s) further include software for performing example aspects, as described above. Included in the programming and/or software of the system are software modules for implementing the procedures described herein. In some example embodiments herein, a module includes software, although in other example embodiments herein, a module includes hardware, or a combination of hardware and software.

While various embodiments of the present disclosure have been described above, it should be understood that they have been presented by way of example, and not limitation. It will be apparent to persons skilled in the relevant art(s) that various changes in form and detail can be made therein. Thus, the present disclosure should not be limited by any of the above described example embodiments, but should be defined only in accordance with the following claims and their equivalents.

Further, the purpose of the Abstract is to enable the Patent Office and the public generally, and especially the scientists, engineers and practitioners in the art who are not familiar with patent or legal terms or phraseology, to determine quickly from a cursory inspection the nature and essence of the technical disclosure of the application. The Abstract is not intended to be limiting as to the scope of the embodiments presented herein in any way. It is also to be understood that any procedures recited in the claims need not be performed in the order presented.

While this specification contains many specific embodiment details, these should not be construed as limitations on what may be claimed, but rather as descriptions of features specific to particular embodiments described herein. Certain features that are described in this specification in the context of separate embodiments can also be implemented in combination in a single embodiment. Conversely, various features that are described in the context of a single embodiment can also be implemented in multiple embodiments separately or in any suitable sub-combination. Moreover, although features may be described above as acting in certain combinations and even initially claimed as such, one or more features from a claimed combination can in some cases be excised from the combination, and the claimed combination may be directed to a sub-combination or variation of a sub-combination. In certain circumstances, multitasking and parallel processing may be advantageous. Moreover, the separation of various components in the embodiments described above should not be understood as requiring such separation in all embodiments, and it should be understood that the described program components and systems can generally be integrated together in a single software product or packaged into multiple software products.

Having now described some illustrative embodiments, it is apparent that the foregoing is illustrative and not limiting, having been presented by way of example. In particular, although many of the examples presented herein involve specific combinations of apparatus or software elements, those elements may be combined in other ways to accomplish the same objectives. Acts, elements and features discussed only in connection with one embodiment are not intended to be excluded from a similar role in other embodiments or embodiments.

The apparatuses described herein may be embodied in other specific forms without departing from the characteristics thereof. The foregoing embodiments are illustrative rather than limiting of the described systems and methods. Scope of the apparatuses described herein is thus indicated by the appended claims, rather than the foregoing description, and changes that come within the meaning and range of equivalence of the claims are embraced therein.

**Claims**

1. A computer-implemented method of calibrating an occupancy grid mapping a vehicle environment, the method comprising:

   identifying, by a controller, a feature of an occupancy grid mapping a vehicle environment, wherein the occupancy grid provides a primary representation of the feature;
   determining, by the controller, a quality level of the primary representation of the feature;
   determining, by the controller, if the quality level satisfies a quality criterion; and
   adjusting, by the controller, a calibration of the occupancy grid if the quality level fails to satisfy the quality criterion, wherein adjusting a calibration of the occupancy grid comprises adjusting at least one parameter used to generate the occupancy grid to cause the quality level to satisfy the quality threshold.

2. The method of claim 1, wherein determining a quality level of the primary representation of the feature comprises:

   obtaining, by the controller, reference information providing a secondary representation of the identified feature, wherein the reference information is obtained independently of the occupancy grid; and
   comparing, by the controller, the secondary representation of the identified feature with the primary representation of the feature from the occupancy grid to determine a disparity between the secondary representation and the primary representation.

3. The method of claim 2, wherein determining if the quality level satisfies a quality criterion comprises determining if the disparity satisfies a tolerance threshold.

4. The method of claim 3, wherein adjusting a calibration of the occupancy grid comprises adjusting at least one parameter used to generate the occupancy grid to reduce the disparity between the secondary representation and the primary representation.

5. The method of claim 4, wherein adjusting at least one parameter used to generate the occupancy grid to reduce the disparity between the secondary representation and the primary representation comprises applying a gradient descent algorithm to the at least one parameter to minimise the disparity.

6. The method of any one of claims 2 to 5, further comprising storing, at a memory, simulation data modelling the dependence of the disparity on the one or more parameters used to generate the occupancy grid.

7. The method of any one of claims 2 to 6, wherein the reference information providing a secondary representation of the identified feature comprises positional data of an object corresponding to the feature, the positional data being obtained from a high definition map module.

8. The method of any one of claims 2 to 6, wherein the reference information providing a secondary representation of the identified feature comprises dynamic positional data obtained from an object tracker module.

9. The method of any preceding claim, wherein the at least parameter comprises one or more of: a decay mean lifetime, a free space confidence level, sensor model type, and a detection uncertainty value.

10. A computer program product comprising computer readable instructions that, when executed by a processor, cause the computer to perform the method of any one preceding claim.

11. A system for calibrating an occupancy grid mapping a vehicle environment, the system comprising a controller configured to:

   identify a feature of an occupancy grid mapping a vehicle environment, wherein the occupancy grid provides a primary representation of the feature;
   determine a quality level of the primary representation of the feature;
   determine if the quality level satisfies a quality criterion; and
   adjust a calibration of the occupancy grid if the quality level fails to satisfy the quality criterion, wherein adjusting a calibration of the occupancy grid comprises adjusting at least one parameter used to generate the occupancy grid to cause the quality level to satisfy the quality threshold.

12. The system of claim 11, wherein determining a quality level of the primary representation of the feature comprises:

obtaining reference information providing a secondary representation of the identified feature, wherein the reference information is obtained independently of the occupancy grid; and comparing the secondary representation of the identified feature with the primary representation of the feature from the occupancy grid to determine a disparity between the secondary representation and the primary representation.

13. The system of claim 12, wherein the reference information providing a secondary representation of the identified feature comprises positional data of an object corresponding to the feature, the positional data being obtained from a high definition map module.

14. The system of claim 12, wherein the reference information providing a secondary representation of the identified feature comprises dynamic positional data obtained from an object tracker module.

15. The system of any one of claims 11 to 14, wherein the at least parameter comprises one or more of: a decay mean lifetime, a free space confidence level, sensor model type, and a detection uncertainty value.

Fig. 1

Vehicle control system 1000

I/O

270

GNSS module

260

HD Maps Module

250

Object Tracker

240

Occupancy Grid Determiner

200

Radar System

210

Lidar System

220

Camera system

230

Device     20

Fig. 2

Fig. 3

Fig. 4A

Fig. 4B

Fig. 5

Fig. 6

Fig. 7

Fig. 8

Identify feature from an occupancy grid    9.1

Determine a quality level of primary representation    9.2

Determine if quality level satisfies a quality criterion    9.3

9.4

Quality criterion satisfied?    YES    END

NO

Adjust calibration of occupancy grid    9.5

Fig. 9

Europäisches
Patentamt

European
Patent Office

Office européen
des brevets

# EUROPEAN SEARCH REPORT

Application Number

EP 21 18 4910

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/293756 A1 (BLAES PATRICK [US] ET AL) 26 September 2019 (2019-09-26) * paragraph [0010] – paragraph [0127]; figures 1-6 * ----- | 1-15 | INV. G06K9/00 G06K9/46 G06K9/62 |
| X | MAROLI JOHN M ET AL: "Automated rotational calibration of multiple 3D LIDAR units for intelligent vehicles", 2017 IEEE 20TH INTERNATIONAL CONFERENCE ON INTELLIGENT TRANSPORTATION SYSTEMS (ITSC), IEEE, 16 October 2017 (2017-10-16), pages 1-6, XP033330271, DOI: 10.1109/ITSC.2017.8317598 [retrieved on 2018-03-14] * page 1, column 1, line 1 – page 5, column 2, last line; figures 1-5 * ----- | 1-4, 10-12 | |

TECHNICAL FIELDS
SEARCHED       (IPC)

G06K

The present search report has been drawn up for all claims

| Place of search | Date of completion of the search | Examiner |
|---|---|---|
| The Hague | 8 December 2021 | Thibault, Guillaume |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons

& : member of the same patent family, corresponding
     document

EPO FORM 1503 03.82 (P04C01)

## ANNEX TO THE EUROPEAN SEARCH REPORT
## ON EUROPEAN PATENT APPLICATION NO.

EP 21 18 4910

This annex lists the patent family members relating to the patent documents cited in  the above-mentioned European search report.
The members are as contained in the European Patent Office EDP file on
The European Patent Office is in no way liable for these particulars which are merely given for the purpose of information.

08-12-2021

| Patent document cited in search report | Publication date | Patent family member(s) | Publication date |
|---|---|---|---|
| US 2019293756 A1 | 26-09-2019 | CN 111936825 A | 13-11-2020 |
| | | EP 3769108 A1 | 27-01-2021 |
| | | JP 2021518553 A | 02-08-2021 |
| | | US 2019293756 A1 | 26-09-2019 |
| | | US 2021055380 A1 | 25-02-2021 |
| | | WO 2019182909 A1 | 26-09-2019 |

EPO FORM P0459

For more details about this annex : see Official Journal of the European Patent Office, No. 12/82